(19) **Europäisches Patentamt / European Patent Office / Office européen des brevets**

(11) **EP 1 816 511 A1**

(12) **EUROPEAN PATENT APPLICATION**

(43) Date of publication:
**08.08.2007 Bulletin 2007/32**

(51) Int Cl.:
***G02F 1/21*** (2006.01)

(21) Application number: **06120048.1**

(22) Date of filing: **04.09.2006**

| | |
|---|---|
| (84) Designated Contracting States:<br>**AT BE BG CH CY CZ DE DK EE ES FI FR GB GR HU IE IS IT LI LT LU LV MC NL PL PT RO SE SI SK TR**<br>Designated Extension States:<br>**AL BA HR MK YU** | (72) Inventors:<br>• **Koyama, Etsuo**<br>  **Toshima-Ku**<br>  **Tokyo 170-6020 (JP)**<br>• **Matsumura, Hiroyoshi**<br>  **Toshima-Ku**<br>  **Tokyo 170-6020 (JP)** |
| (30) Priority: **01.02.2006 JP 2006024236** | (74) Representative: **Grundmann, Dirk et al** |
| (71) Applicant: **Tecdia Co., Ltd.**<br>**170-6020 Tokyo Toshima-ku (JP)** | **Rieder & Partner**<br>**Corneliusstrasse 45**<br>**42329 Wuppertal (DE)** |

(54) **Tunable optical filter and external-resonator-type semiconductor laser device using the same**

(57) In order to reduce the sizes of a tunable optical filter and an external-resonator-type tunable semiconductor laser device, the filter includes: a silicon substrate; a glass substrate which is disposed opposed to the face of the silicon substrate and is equipped with a transparent electrode layer provided over the face thereof disposed to the substrate; an optical diffracting-and-reflecting layer disposed over the face of the silicon substrate; and a liquid crystal layer disposed between the optical diffracting-and-reflecting layer and the transparent electrode layer; and the filter is characterized in that in the filter where the refractive index of the liquid crystal layer is controlled by the voltage applied between the silicon substrate and the transparent electrode layer, a silicon-substrate-side electrode terminal for applying the voltage thereto is provided on the backside of the silicon substrate, this filter being assembled in the external-resonator-type tunable semiconductor laser device.

## Description

BACKGROUND OF THE INVENTION

Field of the Invention

The present invention relates to the tunable optical filter of an external-resonator-type tunable semiconductor laser source used in the field of optical communication technique, for example, and an external-resonator-type semiconductor laser device using this tunable optical filter.

Description of the Related Art

In order to use a semiconductor laser source in the optical communication technique, for example, a light source which has high wavelength-stability in the single-mode oscillation of narrow spectrum line width and which is tunable is required.

External-resonator-type tunable semiconductor laser sources in conventional technique include, for example, a semiconductor laser source having: a semiconductor laser element; a reflecting mirror constituting an external resonator between the end face of the semiconductor laser element from which the laser beam emerges and the mirror; a wavelength-selecting element provided in the external resonator; and a mechanical control means of moving the reflecting mirror along a moving optical axis to enable the resonator length of the external resonator to be change. The resonator length is changed by moving the reflecting mirror, thus enabling the go and return cycle of an optical pulse in the resonator (the frequency of repeated oscillation) to be changed.

However, the size reduction of the external-resonator-type tunable semiconductor laser device using the mechanical control means is difficult, which makes the device need a large casing. Moreover, this semiconductor laser device is weak to the temperature change and the mechanical vibration, and the optical adjustment such as the adjustment of the optical axis of the resonator and the handling of the laser device are complex and difficult. Further, when assembling the external-resonator-type tunable semiconductor laser device in a measuring apparatus, the semiconductor laser device enlarges the whole size of the measuring apparatus.

For this reason, JP-A5-346564 (1993) discloses an external-resonator-type semiconductor laser device having a tunable optical filter using a liquid crystal element. The tunable optical filter using the liquid crystal element operates through the application of the desired voltage. Because of this, this semiconductor laser device has no component mechanically moving, is strong to the temperature change and the mechanical vibration, and is excellent in the stabilities of the oscillation wavelength, the repetitive frequency, and the plane of polarization, thus operating with stability for a long period.

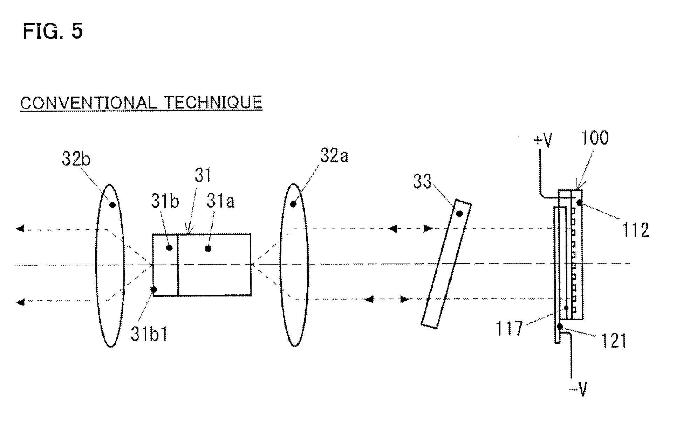

FIG. 5 is a view schematically showing the configuration of the conventional example. The external-resonator-type tunable semiconductor laser device shown in FIG. 5 includes: a semiconductor laser element 31 equipped with a saturable absorption region 31b and a gain region 31a; a tunable optical filter 100 constituting an external resonator between a saturable-absorption-region-side end face 31b1 and the optical filter; a collimating lens 32a which is provided between these semiconductor laser element 31 and tunable optical filter 100 and which optically combines these components; and a wavelength-selecting element 33 provided between this collimating lens 32a and the tunable optical filter 100. And this external-resonator-type tunable semiconductor laser device is arranged to take out the light output from the saturable-absorption-region-side end face 31b1 through the collimating lens 32b.

The light, which emerged from the semiconductor laser element 31, is collimated by the collimating lens 32a, and reaches the tunable optical filter 100 through the wavelength-selecting element 33. And only the light beam of the desired wavelength is reflected by the tunable optical filter 100, passes through the wavelength-selecting element 33 again, and is re-injected into the semiconductor laser element 31 through the collimator lens 32a. Further, the repetitive reflection carried out by the external resonator consisting of the saturable-absorption-region-side end face 31b1 of the semiconductor laser element 31 and the tunable optical filter 100 performs the laser oscillation.

The wavelength of the light reflected by the tunable optical filter 100 can be controlled by the voltage ($\pm$V) applied to a liquid crystal element 117. The electrode terminals for applying the voltage thereto are taken out from a silicon substrate 112 (+V) and the transparent electrode layer (-V) provided on a glass substrate 121. Additionally, because the register marks of the silicon substrate 112 are provided on the front face of the substrate, the silicon-substrate-side electrode terminal has been conventionally taken out from the front face of the substrate.

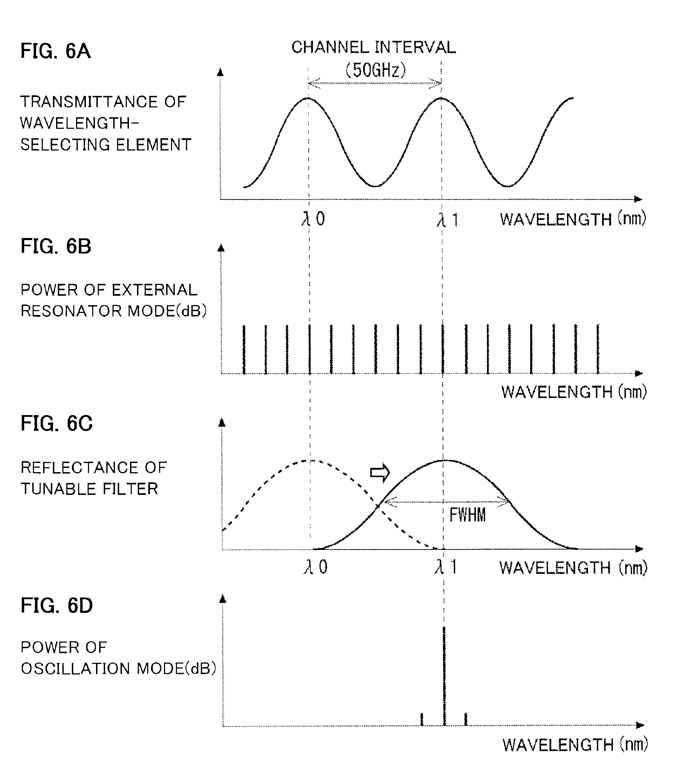

In the configuration of the semiconductor laser device shown in FIG. 5, the process of arbitrarily converting the wavelength of laser oscillation is shown in FIGs. 6A-6D.

The light transmittance of the wavelength-selecting element 33 is arranged to be periodically changed at intervals of the predetermined wavelength channel as shown in FIG. 6A. At present, in order to meet the increase of the volume of communication traffic and information, the wavelength division multiplexing communication system of which the wavelength channel interval is 50 GHz is being developed, and in that case, the interval of the wavelength channel is set to 50 GHz. Meanwhile, the oscillation mode of the external oscillator is intermittent to the wavelength as shown in FIG. 6B. Accordingly, in each wavelength channel region where the light transmittance of the wavelength-selecting element 33 is the maximum, the external oscillator mode is substantially periodically selected.

Furthermore, as shown in FIG. 6C, the reflectance of the tunable optical filter 100 presents the characteristic of the Lorentz distribution having a predetermined peak wavelength, and the voltage is applied to the liquid crystal element, which is provided in the tunable optical filter 100, to control the refractive index thereof, thus enabling the peak wavelength of reflectance thereof to be moved or changed by an integral multiple of the interval of the wavelength channel. Thereby, the tunable optical filter 100 functions as an optical filter selecting the wavelength channel region, and as shown in FIG. 6D, the desired wavelength channel region is selected in the wavelength region in which the reflectance of the tunable filter 100 is the maximum. This selects only the resonator mode that is required by the laser oscillation. As a result, other external resonator modes are removed, and the light output levels other than the laser oscillation mode become extremely small.

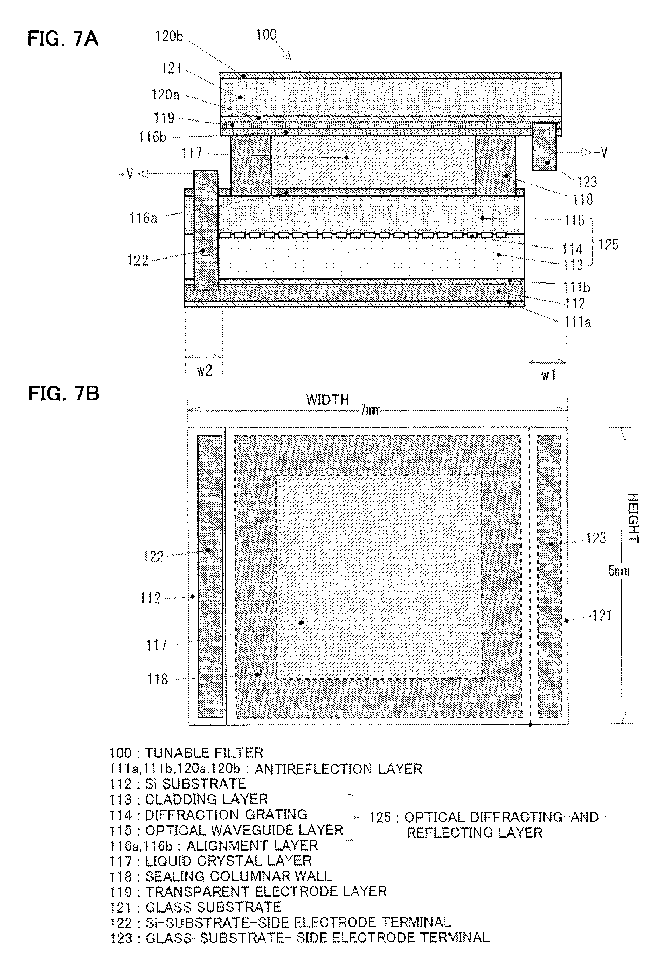

FIGs. 7A and 7B are views schematically showing the arrangement of the conventional tunable optical filter 100 shown in FIG. 5, FIG. 7Abeing the longitudinal sectional view thereof, and FIG. 7B being the plan view thereof.

The tunable optical filter 100 includes the silicon substrate 112 and the glass substrate 121 which is disposed opposed to the silicon substrate and which is equipped with a transparent electrode layer 119 provided over the face thereof opposed to the silicon substrate. In addition, an optical diffracting-and-reflecting layer 125 is disposed over the front face of the silicon substrate, and a liquid crystal layer 117 is disposed between the optical diffracting-and-reflecting layer 125 and the transparent electrode layer 119. The periphery of the liquid crystal layer 117 is sealed by a sealing columnar wall 118.

The optical diffracting-and-reflecting layer 125 consists of a cladding layer 113, a diffraction grating 114, and an optical waveguide layer 115, which are disposed in order from the side of the silicon substrate 112.

In addition to these layers, both the faces of each of the silicon substrate 112 and the glass substrate 121 are covered with antireflection layers 111a and 111b, and 120a and 120b, respectively. Moreover, the faces of the transparent electrode layer 119 and the optical waveguide layer 115, which are in contact with the liquid crystal layer 117, are covered with alignment layers 116a, 116b, respectively.

In the tunable optical filter arranged as described above, the alignment of the liquid crystal layer 117 is changed by the voltage applied between the silicon substrate 112 and the transparent electrode layer 119 to control the refractive index of the liquid crystal layer, thus enabling the wavelength of the light diffracted and reflected to be changed.

As shown in FIG. 7A, the glass-substrate-side electrode terminal 123 is taken out from the transparent electrode layer 119 provided over the glass substrate 121 on one side of the longitudinal section, and the silicon-substrate-side electrode terminal 122 is taken out from the face of the silicon substrate 112, that is, the face thereof on the side of the optical diffracting-and-reflecting layer 125 on another side thereof.

With the objective of taking out the glass-substrate-side electrode terminal 123 therefrom, in order to obtain the taking-out width w1, the glass substrate 121 extends out from the silicon substrate 112.

Meanwhile, with the objective of taking out the silicon-substrate-side electrode terminal 122 therefrom, in order to obtain the taking-out width w2, the silicon substrate 112 extends out from the glass substrate 121. Conventionally, the silicon substrate 112 and the optical diffracting-and-reflecting layer 125 have been manufactured by use of the present silicon semiconductor manufacturing process, and in order to obtain the consistency of the manufacturing process, the silicon-substrate-side electrode terminal 122 could be taken out only from the front face of the silicon substrate 112.

To be more specific, this depends on the following reasons. As disclosed in JP-A10-209009(1998) and JP-A2005-340321, conventionally, in the process of forming the silicon-substrate-side electrode terminal 122, register marks (concavities, convexities or the like) provided on the front face of the silicon substrate have been used. These register marks are used when carrying out a variety of processes such as the pattern forming on the front face of the silicon substrate or the like process. However, because of the large thickness of the silicon substrate, the register mark provided on the face thereof could not be detected by the observation performed from the backside of the silicon substrate by using visible light. For this reason, conventionally, the silicon-substrate-side electrode terminal 122 had to be taken out from the front face of the silicon substrate 112.

However, JP-A2005-221368 and JP-A2005-311243 disclose the method of detecting the register marks provided on the front face of the silicon substrate from the backside of the silicon substrate by use of infrared rays to perform the failure analysis of the semiconductor element formed on the silicon substrate.

JP-A2005-221368 discloses a light source portion, which outputs infrared light in the wavelength region where the light passes through the silicon substrate, and also discloses an apparatus, which obtains the observation data on a reflection position by: taking the images of a first reflected light, which is reflected from the backside of the substrate when the light outputted from the light source portion was irradiated on the backside of the substrate and a second reflected light, which passed through the substrate and then was reflected from the interior and the front face of the substrate; and performing operations on each of the image data thereof.

JP-A2005-311243 discloses a silicon substrate having the characteristic of allowing infrared rays to pass therethrough, and also discloses that the observation of the semiconductor elements provided on the front face of the substrate is performed from the backside of the substrate by spacing apart and disposing, within the observation view, semiconductor elements, which were provided on the front face of the substrate and which serve as registration portions, in an amount of three or more pieces, such that the distance between the elements becomes 1/2 or less of the range of the minimum observation view of the backside analysis system.

The conventional tunable optical filter is large in size as shown in the plan view of FIG. 7B, having a height (the short side thereof in the rectangular plane) of about 5 mm, and a width (the long side thereof in the rectangular plane) of about 7 mm, and the casing of the external-resonator-type semiconductor laser device using this tunable optical filter is as long as about 12 mm in height and 16 mm in width.

The 10 GHz optical communication system for the next generation is being developed now, and the transponder used to the trunk line system thereof is designed small. The size of the casing of the external-resonator-type semiconductor laser device built in the transponder is restricted by the size of the transponder used for the optical communication system, and it has been necessary for the casing thereof to have a height that is smaller than 9 mm and a width that is smaller than 13 mm. Moreover, in order to cause the semiconductor laser device to efficiently oscillate and also to increase the efficiency of the temperature control because the device is used under the temperature control of 50°C, reducing the size of the casing of the external-resonator-type semiconductor laser device to the value smaller than the above-described one has become necessary. In addition, the interior of the casing of the external-resonator-type semiconductor laser device must have: the space in which a Peltier element for temperature control and a stem used for mounting components are assembled; the space from which the electrodes for the semiconductor laser and the tunable optical filter are taken out; and the space to which these parts are secured. In view of the thickness of the casing thereof, there is a strong demand that the tunable optical filter is 3 mm or less in height and 4.5 mm or less in width.

However, as shown in FIG. 7A, in the conventional tunable optical filter 100, the liquid crystal layer 117 is sealed between the silicon substrate 112 and the glass substrate 121 by use of the sealing columnar wall 118. And it is necessary for the sealing columnar wall 118 to have a width of 0.5 mm or more because of the restrictions in the processing technology. Furthermore, it is requisite for the cutting allowance from the sealing columnar wall 118 to have a width of 0.2 mm or more because of the restrictions in the cutting and splitting technology of glass.

Further, the width of the electrode terminal needs to be 0.6 mm or more due to the restrictions of the manufacturing technology of bonding the copper wire of 0.5 mm diameter, for example, to the silicon-substrate-side electrode terminal 122 and to the glass-substrate-side terminal 123, respectively. Because of the restrictions of the cutting and splitting technology of the glass substrate and the silicon substrate, the width of the cutting allowance from the silicon-substrate-side electrode terminal 122 and the glass-substrate-side electrode terminal 123 needs to be 0.2 mm or more. In that case, each of the taking-out widths w1, w2 shown in FIG. 7A needs to be 0.8 mm or more.

In addition, if the silicon-substrate-side electrode terminal 122 is taken out from the backside of the silicon substrate 112, the taking-out width w2 shown in FIG. 7A becomes unnecessary; however, it was very difficult to take out the electrode terminal from the backside of the silicon substrate 112 as described hereinabove.

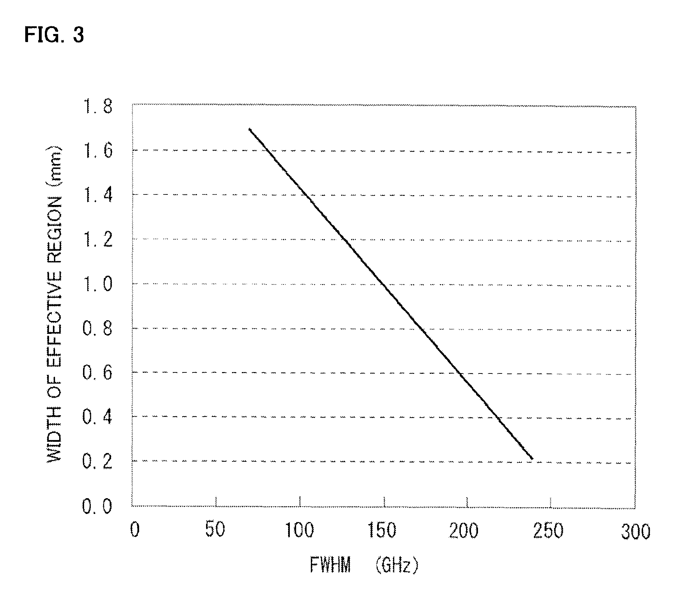

Furthermore, because of the problem that the width of an effective region (to be explained in FIG. 3 described later) within the face of the optical diffracting-and-reflecting layer 125 is behind the sealing columnar wall 118, the gap between the width of the effective region and the sealing columnar wall 118 needs to be 0.2 mm or more.

Therefore, when all the above-described size-conditions are satisfied, the height and the width of the conventional tunable optical filter need to be at least 3.3 mm and at least 5.3 mm, respectively.

As described hereinabove, it was very difficult to reduce the size of the conventional tunable filter in the structure thereof to 3 mm or less in height and 4.5 mm or less in width. For information, the reduction of the width of the sealing columnar wall to 0.2 mm was simply tried; however, the strength of the columnar wall became extremely reduced, and the manufacturing yield deteriorated, the columnar wall becoming unpractical.

For this reason, an object of the present invention is to reduce the size of the tunable optical filter to 3 mm or less in height and 4.5 mm or less in width, and properly to 4 mm in width. Further, another object of the present invention is to provide an external-resonator-type tunable semiconductor laser device that can obtain wavelength tunability with a high degree of accuracy under any operating conditions, does not require the special provision of correction means such as a wavelength locker, and can be accommodated in a transponder of 10 GHz for the next generation, by building the downsized tunable optical filter into an external-resonator-type semiconductor laser device.

SUMMARY OF THE INVENTION

In order to realize the above-mentioned object, the present invention provides the following arrangement. The numerals in the parentheses are reference numerals in the drawings.

(1) A tunable optical filter according to a first aspect of the present invention, includes: a silicon substrate (12); a glass substrate (21) which is disposed opposed to the front face of the silicon substrate and which is equipped with a transparent electrode layer

(19) provided over the face of the glass substrate opposed to the silicon substrate; an optical diffracting-and-reflecting layer (25) disposed over the front face of the silicon substrate; and a liquid crystal layer disposed between the optical diffracting-and-reflecting layer and the transparent electrode layer; and the tunable optical filter is characterized in that in the tunable optical filter (1) where the refractive index of the liquid crystal layer is controlled by the voltage applied between the silicon substrate and the transparent electrode layer, a silicon-substrate-side electrode terminal (22) used for applying the voltage therebetween is provided on the backside of the silicon substrate.

(2) A tunable optical filter according to a second aspect of the present invention is characterized in that, in accordance with the first aspect thereof, the tunable optical filter includes a sealing columnar wall (18) sealing the periphery of the liquid crystal layer, and in the longitudinal section, the silicon-substrate-side electrode terminal (22) is located inwardly from the external fringe of the sealing columnar wall (18).

(3) A tunable optical filter according to a third aspect of the present invention is characterized in that, in accordance with the first or the second aspect thereof, the half width of the reflectance of the light that is diffracted and reflected by the optical diffracting-and-reflecting layer (25) is 80-150 GHz.

(4) A tunable optical filter according to a fourth aspect of the present invention is characterized in that, in accordance with any of the first to the third aspects thereof, the height of the tunable optical filter is 3 mm or less and the width thereof is 4.5 mm or less.

(5) An external-resonator-type tunable semiconductor laser device according to a fifth aspect of the present invention is characterized of including the tunable optical filter as set forth in any of (1)-(3), described above.

In the tunable optical filter according to the first or the second aspect of the present invention, the silicon-side electrode terminal, which is one of the electrode terminals for applying the voltage that controls the refractive index of the liquid crystal layer in order to change the wavelength of the diffracted and reflected light, is taken out from the backside of the silicon substrate. This eliminates the necessity of the taking-out width (w2 in FIG. 7A), which was conventionally necessary when taking out the silicon-side electrode terminal from the front face of the silicon substrate, and thereby, the width of the silicon substrate can be reduced by just that width.

In the tunable optical filter according to the third aspect of the present invention, the width of the effective region in the face of the optical diffracting-and-reflecting layer can be reduced by setting the half width of the reflectance of the diffracted and reflected light to 100-150 GHz. This can reduce the area of the optical diffracting-and-reflecting layer.

The tunable optical filter according to the fourth aspect of the present invention is 3 mm maximum in height and 4.5 mm maximum in width. This can reduce the size of the external-resonator-type tunable semiconductor laser device in which this filter is built, and can enable this semiconductor laser device to be accommodated by the 10 GHz wavelength division multiplexing optical communication transponder for the next generation.

The external-resonator-type tunable semiconductor laser device according to the fifth aspect of the present invention can shrink in the whole dimensions by having the downsized tunable optical filter built therein, which enables this semiconductor laser device to be accommodated by the 10 GHz wavelength division multiplexing optical communication transponder for the next generation.

BRIEF DESCRIPTION OF THE DRAWINGS

FIG 1 is a schematic configuration diagram of an external-resonator-type semiconductor laser device including a tunable optical filter according to the present invention;
FIG 2A is a longitudinal sectional view schematically showing the structure of the tunable optical filter shown in FIG 1;
FIG 2B PLAN VIEW A is a plan view of the tunable optical filter shown in FIG 1, and FIG 2B BACKSIDE VIEW B is a backside view thereof;
FIG 3 is a graph showing the relation between the width of the effective region of the tunable optical filter with which a reflectance of 98 percent or more is obtained and the FWHM of the reflectance;
FIGs. 4A-4H are views showing the method of fabricating the tunable optical filter 1 according to the present invention, shown in FIG 2A;
FIG 5 is a view schematically showing the configuration of a conventional external-resonator-type tunable semiconductor laser device;
FIGs. 6A-6D are views showing the process of arbitrarily converting the oscillation wavelength of the laser in the semiconductor laser device shown in FIG. 5; and
FIGs. 7A and 7B are views schematically showing the structure of the conventional tunable optical filter shown in FIG. 5, FIG. 7A being the longitudinal sectional view thereof, and FIG. 7B being the plan view thereof.

DETAILED DESCRIPTION OF THE PREFERRED EMBODIMENT

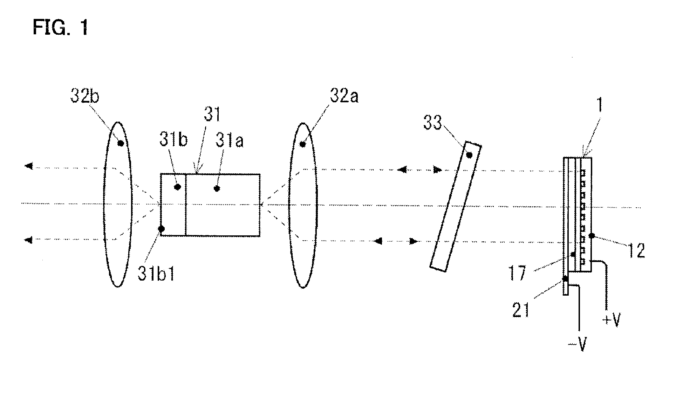

FIG 1 is a schematic configuration diagram of an external-resonator-type semiconductor laser device including a tunable optical filter 1 according to the present invention. The external-resonator-type tunable semiconductor laser device shown in FIG. 1 basically has the same configuration as that of the conventional laser device show in FIG. 5 except the structure of the tunable optical filter 1.

The external-resonator-type tunable semiconductor laser device shown in FIG. 1 includes: a semiconductor laser element 31 equipped with a saturable absorption region 31b and a gain region 31a; a tunable optical filter 1 constituting an external resonator between a saturable-absorption-region-side end face 31b1 and the optical filter; a collimating lens 32a that is provided between these semiconductor laser element 31 and tunable optical filter 1 and optically combines these components; and a wavelength-selecting element 33 provided between this collimating lens 32a and the tunable optical filter 1. The external-resonator-type tunable semiconductor laser device is arranged to take out the light output from the saturable-absorption-region-side end face 31b1 through the collimating lens 32b.

Herein, in order to slightly change the length of the resonator, the semiconductor laser having the saturable absorption region 31b was selected; however, the semiconductor laser having a structure in which this function is supplemented by changing the temperature of the Peltier element can be also used, and this region 31b is not the essential element.

The wavelength of the light reflected by the tunable optical filter 1 can be controlled by the voltage ($\pm$V) applied to a liquid crystal element 17. The electrode terminals to apply the voltage thereto are taken out from a silicon substrate 12 (+V) and the transparent electrode layer (-V) provided over a glass substrate 21. According to the present invention, in contrast to the conventional technique, the silicon-substrate-side electrode terminal is taken out from the backside of the silicon substrate 12.

Additionally, in the configuration of the semiconductor laser device shown in FIG. 1, the process of arbitrarily converting the oscillation wavelength of the laser is basically the same as that described by referring to FIGs. 6A-6D in the paragraph of Description of the Related Art.

As described hereinabove, it was very difficult to reduce, in the structure of the conventional tunable filter, the size of the tunable filter to 3 mm or less in height and 4.5 mm or less in width. One of the reasons therefor is that the silicon-substrate-side electrode terminal is taken out from the front face of the silicon substrate as shown in the configuration diagram shown in FIGs.7A and 7B. This is because, as described hereinabove, it was difficult to detect the register marks provided on the front face of the silicon substrate from the backside thereof.

However, by virtue of innovation in the recent silicon semiconductor manufacturing process, and particularly, because of the developed technology detecting the register marks of the silicon substrate from the backside thereof by using infrared rays (see JP-A2005-221368 and JP-A2005-311243), taking out the silicon-substrate-side electrode terminal from the backside of the silicon substrate has become possible. For this reason, as shown in FIG. 1, the large size-reduction of the tunable optical filter became possible by making the optical filter have the structure in which the silicon-substrate-side electrode terminal is taken out from the backside of the silicon substrate.

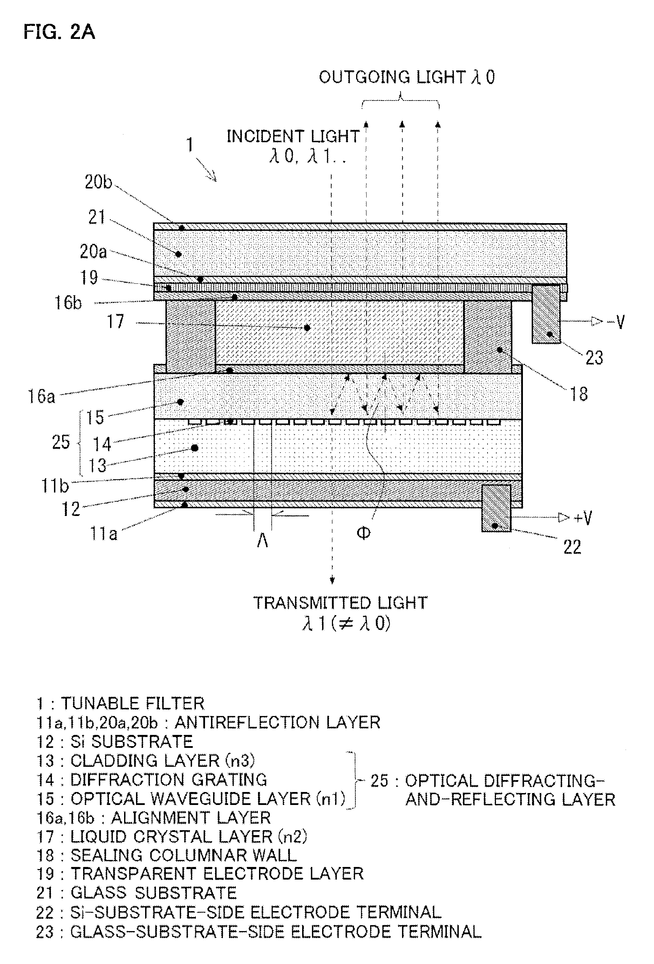

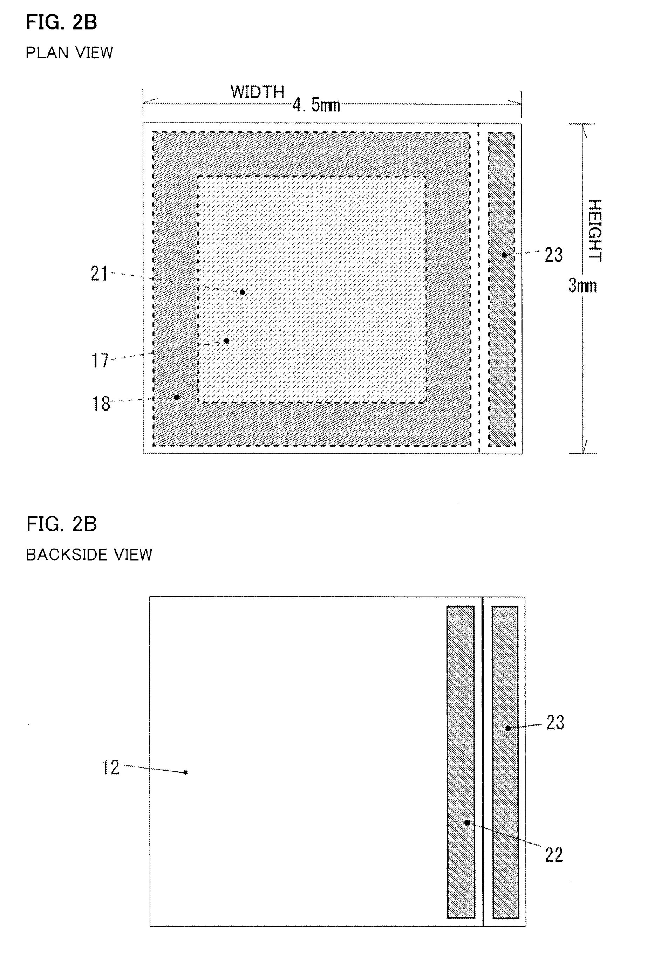

FIG 2A is a longitudinal sectional view schematically showing the structure of the tunable optical filter 1 shown in FIG 1 (The vertical sizes are enlarged). FIG. 2B PLAN VIEW A is the plan view thereof, and FIG. 2B BACKSIDE VIEW B is the backside view thereof.

The tunable optical filter 1 includes the silicon substrate 12 and the glass substrate 21 which is disposed opposed to the front face of the silicon substrate 12 and which is equipped with a transparent electrode layer 19 provided over the face thereof opposed to the silicon substrate 12. In addition, an optical diffracting-and-reflecting layer 25 is disposed over the front face of the silicon substrate, and the liquid crystal layer 17 is disposed between the optical diffracting-and-reflecting layer 25 and the transparent electrode layer 19. The periphery of the liquid crystal layer 17 is sealed by a sealing columnar wall 18.

The optical diffracting-and-reflecting layer 25 consists of a cladding layer 13, a diffraction grating 14, and an optical waveguide layer 15, which are disposed in order from the side of the silicon substrate 12.

In addition to these layers, both the faces of each of the silicon substrate 12 and the glass substrate 21 are covered with antireflection layers 11a and 11b, and 20a and 20b, respectively. Further, the faces of the transparent electrode layer 19 and the optical waveguide layer 15, which are in contact with the liquid crystal layer 17, are covered with alignment layers 16a, 16b, respectively.

In the tunable optical filter arranged as described above, the alignment of the liquid crystal layer 17 is changed by the voltage applied between the silicon substrate 12 and the transparent electrode layer 19 to control the refractive index of the liquid crystal layer, thus enabling the wavelength of the light diffracted and reflected to be changed.

As shown in FIG. 2A, a glass-substrate-side electrode terminal 23 is taken out from the transparent electrode layer 19 provided over the glass substrate 21 on one side of the longitudinal section, and in the periphery of the same side, a silicon-substrate-side electrode terminal 22 is taken out from the backside of the silicon substrate 12, that is, the face thereof opposite from the optical diffracting-and-reflecting layer 25.

With the objective of taking out the glass-substrate-side electrode terminal 23 therefrom, in order to obtain the taking-out width, the glass substrate 21 extends out from the silicon substrate 12 as similarly in the case of the conventional example shown in FIG. 7A.

Meanwhile, because the silicon-substrate-side electrode terminal 22 is taken out from the backside of the silicon substrate 12, the silicon substrate 12 need not to extend out from the glass substrate 21, in contrast to the conventional example shown in FIG. 7A, and the width of the tunable optical filter can be reduced by just that width. In other words, contrasted with the conventional example, the silicon-substrate-side electrode terminal 22 can be disposed inwardly from the external fringe of the sealing columnar wall 18 in the longitudinal section. The silicon-substrate-side electrode terminal 22 can be, in principle, provided in an arbitrary area other than the area in which the light is reflected and passes therethrough as long as the area is located on the backside of the silicon substrate 12.

The optical paths of the incident light, reflected light, and transmitted light are shown in FIG. 2A by the dashed lines. The principle of the operation of the tunable optical filter is described by referring to this drawing. The light made incident at wavelength λ (containing different wavelengths λ0, λ1 ... at channel intervals, as shown in FIG. 6A described above) is diffracted by a diffraction grating 14, and is made incident on the optical waveguide layer 15 of a refractive index of n1 at an angle Φ. This angle Φ is determined by the cycle A of the diffraction grating 14, and is given by the next formula. Here, only the first diffracted light is considered.

$$\mathrm{Sin}\Phi = \lambda/\Lambda\ \mathrm{n1} \qquad (1)$$

When the propagation angle Φ of a single mode, which can propagate within the optical waveguide layer 15, agrees with the diffraction angle Φ of the incident light by the diffraction grating 14, given by the formula (1) (Φ=Φ), the incident light is coupled to the single mode propagating within the optical waveguide layer 15 to discharge all the energy thereof to the single mode, and progresses in a zigzag line in an intra-layer direction within the optical waveguide layer 15. It is assumed that the light with wavelength λ0 satisfies Φ=Φ in the case of FIG. 2A. As the light propagates in a zigzag line within the optical waveguide layer 15, the single mode propagating at the propagating angle Φ=Φ is influenced by the diffraction grating 14 located on the side of the cladding layer 13, and sequentially diffracts the light of wavelength λ0 in the opposite direction to the incident light to gradually disappear. This diffracted light emerges as the reflected light in the opposite direction to the incident direction.

In contrast, with the light made incident at a wavelength λ1 (≠λ), because the diffraction angle Φ1 of the light does not agree with the propagating angle Φ of the single mode propagating within the optical waveguide layer 15 Φ≠Φ1, the incident light cannot propagate in the optical waveguide layer 15, and emerges from the direction of the backside of the silicon substrate 12 as the transmitted light.

Here, when a voltage V was applied between the silicon-substrate-side electrode terminal 22 and the glass-substrate-side electrode terminal 23, shown in FIG.2A, the alignment of the liquid crystal layer 17 thereby changes, and the refractive index n2 thereof changes. As a result, the propagation angle Φ of the single mode, which propagates within the optical waveguide layer 15, changes into Φ1. The control of the voltage V can cause the diffraction angle Φ1 of the light of wavelength λ1 to agree with this propagating angle Φ1 (Φ1=Φ1). Thereby, the energy of the incident light of wavelength λ1 is all coupled or transferred to the single mode propagating within the optical waveguide layer, and diffracts the light of wavelength λ1 by receiving the influence of the diffraction grating to become the reflected light (see FIG. 6C described above).

Subsequently, the incident light is diffracted by the diffraction grating 14, and then travels in a zigzag form in the intra-layer direction within the optical waveguide layer 15. The longer this travel distance (the width of the effective region), the larger the amount of the diffracted and reflected light becomes, and the higher reflection energy is obtained. That is, the wider the width of the effective region of the tunable optical filter 1, the closer the reflectance thereof gets to 100 percent. The tunable optical filter reflects all the light of a specific wavelength (for example λ0) in the incident light, and allows the light of other wavelengths to pass therethrough, becoming an optical filter with high sensitivity.

As shown in FIG. 6C described above, in general, the reflectance of the tunable optical filter 1 is somewhat broad with respect to the wavelength. This broadening has a Lorentz distribution, and is determined chiefly by the depth and the groove width of the diffraction grating 14. The width of the broadening in which the reflectance is one-half of the maximum reflectance is particularly referred to as FWHM (Full Width Half Maximum).

FIG 3 is a graph showing the relation between the width of the effective region of the tunable optical filter with which a reflectance of 98 percent or more is obtained and the FWHM of the reflectance. In the external-resonator-type tunable semiconductor laser device used under present circumstances, the oscillation wavelength is selected at channel intervals of 50 GHz as described in FIG. 6A described above; however, the FWHM of the tunable optical filter is set to 100 GHz or less in accordance with the channel interval. According to the graph shown in FIG. 3, when the FWHM is 100 GHz or less, the width of the effective region of the tunable optical filter needs to be 1.4 mm or more. This has been also a limit of reduction of the height and the width of the tunable filter.

Further, at the present time, in order to meet the increase of the volume of communication traffic and information, the wavelength division multiplexing communication system of which the channel interval is 50 GHz is developed, and the external-resonator-type semiconductor laser device is designed such that the light transmittance of the wavelength-selecting element periodically changes at intervals of 50 GHz. In the region (channel) where the light transmittance becomes the maximum, the external resonator mode is substantially periodically selected at each channel. For this reason, the FWHM of the tunable filter does not necessarily require to be set to 100 GHz or less. Even if the FWHM thereof is 80 GHz or more, as long as the FWHM is smaller than the FWHM of which the possibility that the wavelengths other than the oscillation wavelength of the external resonator laser are selected at the same time is low, the FWHM of the tunable filter may be enlarged. The experiments resulted in the discovery that the FWHM thereof can be increased up to 150 GHz.

Thereby, as will be inferred from FIG. 3, the width of the effective region of the tunable optical filter, that is, the width of the region on which the light is substantially made incident and the light is reflected can be reduced down to the length of the order of 1.3 mm.

As described hereinabove, first, the silicon-substrate-side electrode terminal is taken out from the backside of the silicon substrate, and second, the depth and the groove width of the diffraction grating are set such that the FWHM of the tunable optical filter is 80-150 GHz, which enables the height and the width of the tunable optical filter to be reduced to 3 mm or less and 4.5 mm or less, respectively.

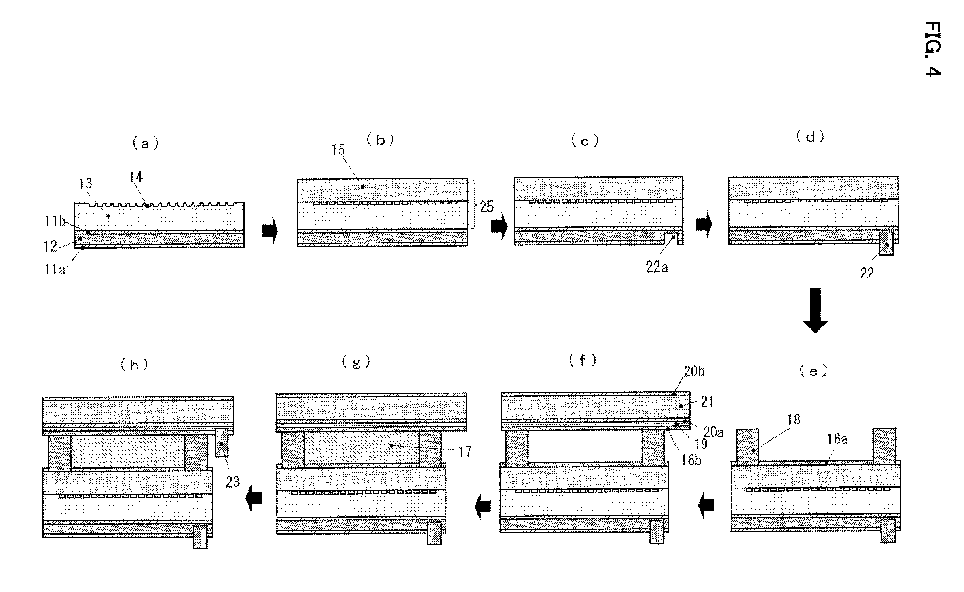

FIGs. 4A-4H are views schematically showing one example of the method of fabricating the tunable optical filter 1 according to the present invention, shown in FIG 2A.

Step (a): Antireflection films 11a, 11b, each consisting of $SiO_2$ and $Si_3N_4$ are formed over both the faces of the silicon substrate 12, and then the cladding layer 13 which has a refractive index of n3 and which is a dielectric film ($SiO_2$) that is substantially as thick as the wavelength, is formed. Further, the diffraction grating 14 having a cycle length A is formed in the form of a stripe on the top surface of the cladding layer 13 by processing the surface thereof. The cycle length A of this diffraction grating 14 is determined such that the grating satisfies the condition of the so-called Bragg reflection in order to diffract and reflect the light of the desired wavelength.

Step (b) : A dielectric film ($Si_3N_4$) having a refractive index of n1 (n1>n3) is thickly formed over the diffraction grating 14 of dielectric film formed in the form of a stripe and buried therein to form the optical waveguide layer 15. The thickness of the optical waveguide layer 15 is determined by: the refractive index n3 of the cladding layer 13; the refractive index n1 of the optical waveguide layer 15; and the refractive index n2 (n1>n2>n3) of the liquid crystal layer 17, which is described later; such that the condition of the so-called single-mode propagation under which only the optical mode of the wavelength $\lambda$, which is wanted to be reflected by this optical waveguide layer 15, propagates is satisfied. Thereby, the optical diffracting-and-reflecting layer 25 is formed.

Step (c): After that, in order to form an ohmic contact with the silicon substrate 12, a stripe-shaped groove used for forming the silicon-substrate-side electrode terminal is formed or excavated on the backside of the silicon substrate 12 by etching the substrate thereof. This processing is performed while detecting the register marks formed on the front face of the silicon substrate 12 by using infrared rays from the backside thereof.

Step (d): A metal film, which becomes the silicon-substrate-side electrode 22, is buried in the stripe-shaped groove excavated on the backside of the silicon substrate 12.

Step (e) : After that, the alignment layer 16a, which aligns the liquid crystal, is formed over the front face of the optical waveguide layer 15, and the sealing columnar wall 18 having a height and a width, which are substantially as long as the wavelength of the light, is formed at the predetermined position on the alignment layer. However, the inlet for the liquid crystal is provided.

Step (f): Meanwhile, the glass substrate 21 is prepared, of which both the faces were formed with antireflection films 20a, 20b, then, of which one face was formed with the transparent electrode layer 19, and further, of which one face was formed with the alignment layer 16b. This glass substrate 21 is placed over the silicon substrate 12 such that the transparent electrode layer 19 side of the glass substrate is opposed to the silicon substrate 12.

Step (g) : A liquid crystal of refractive index n2 (n1>n2>n3) is poured into the clearance between the silicon substrate 12 and the glass substrate 21, and the inlet is covered and sealed with the sealing columnar wall 18 to form the liquid crystal layer 17.

Step (h): Then, the glass substrate 21 and the silicon substrate 12 are cut to the desired size. The glass-substrate-side electrode terminal 23 is formed such that the terminal forms an ohmic contact with the transparent electrode layer 19.

**Claims**

1. A tunable optical filter including:

   a silicon substrate (12);
   a glass substrate (21) which is disposed opposed to the front face of the silicon substrate and which is equipped with a transparent electrode layer (19) provided over the face of the glass substrate opposed to the silicon substrate;
   an optical diffracting-and-reflecting layer (25) disposed over the front face of the silicon substrate; and
   a liquid crystal layer disposed between the optical diffracting-and-reflecting layer and the transparent electrode layer; wherein
   in the tunable optical filter (1) where the refractive index of the liquid crystal layer is controlled by the voltage applied between the silicon substrate and the transparent electrode layer, a silicon-substrate-side electrode terminal (22) used for applying the voltage therebetween is provided on the backside of the silicon substrate.

2. A tunable optical filter according to Claim 1, wherein the tunable optical filter includes a sealing columnar wall (18) sealing the periphery of the liquid crystal layer, and in the longitudinal section, the silicon-substrate-side electrode terminal (22) is located inwardly from the external fringe of the sealing columnar wall (18).

3. A tunable optical filter according to Claim 1 or 2, wherein the half width of the reflectance of the light that is diffracted and reflected by the optical diffracting-and-reflecting layer (25) is 80-150 GHz.

4. A tunable optical filter according to any of Claims 1-3, wherein the height thereof is 3 mm or less and the width thereof is 4.5 mm or less.

5. An external-resonator-type tunable semiconductor laser device including the tunable optical filter as set forth in any of Claims 1-4.

FIG. 1

## FIG. 2A

1 : TUNABLE FILTER
11a,11b,20a,20b : ANTIREFLECTION LAYER
12 : Si SUBSTRATE
13 : CLADDING LAYER (n3)
14 : DIFFRACTION GRATING          25 : OPTICAL DIFFRACTING-
15 : OPTICAL WAVEGUIDE LAYER (n1)       AND-REFLECTING LAYER
16a,16b : ALIGNMENT LAYER
17 : LIQUID CRYSTAL LAYER (n2)
18 : SEALING COLUMNAR WALL
19 : TRANSPARENT ELECTRODE LAYER
21 : GLASS SUBSTRATE
22 : Si-SUBSTRATE-SIDE ELECTRODE TERMINAL
23 : GLASS-SUBSTRATE-SIDE ELECTRODE TERMINAL

## FIG. 2B

PLAN VIEW

## FIG. 2B

BACKSIDE VIEW

FIG. 3

FIG. 4

FIG. 5

CONVENTIONAL TECHNIQUE

**FIG. 6A**

TRANSMITTANCE OF
WAVELENGTH-
SELECTING ELEMENT

CHANNEL INTERVAL
(50GHz)

$\lambda 0$    $\lambda 1$    WAVELENGTH (nm)

**FIG. 6B**

POWER OF EXTERNAL
RESONATOR MODE(dB)

WAVELENGTH (nm)

**FIG. 6C**

REFLECTANCE OF
TUNABLE FILTER

FWHM

$\lambda 0$    $\lambda 1$    WAVELENGTH (nm)

**FIG. 6D**

POWER OF
OSCILLATION MODE(dB)

WAVELENGTH (nm)

FIG. 7A

FIG. 7B

WIDTH
7mm

HEIGHT
5mm

100 : TUNABLE FILTER
111a,111b,120a,120b : ANTIREFLECTION LAYER
112 : Si SUBSTRATE
113 : CLADDING LAYER
114 : DIFFRACTION GRATING
115 : OPTICAL WAVEGUIDE LAYER
116a,116b : ALIGNMENT LAYER
117 : LIQUID CRYSTAL LAYER
118 : SEALING COLUMNAR WALL
119 : TRANSPARENT ELECTRODE LAYER
121 : GLASS SUBSTRATE
122 : Si-SUBSTRATE-SIDE ELECTRODE TERMINAL
123 : GLASS-SUBSTRATE- SIDE ELECTRODE TERMINAL

125 : OPTICAL DIFFRACTING-AND-
REFLECTING LAYER

**European Patent Office**

# EUROPEAN SEARCH REPORT

Application Number

EP 06 12 0048

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WO 2005/064365 A (PIRELLI & C SPA [IT]; PIETRA GIULIA [IT]; GORNI GIACOMO MARIA [IT]) 14 July 2005 (2005-07-14) * page 16, line 3 - page 17, line 8; figure 8 * ----- | 1,5 | INV. G02F1/21 |
| Y | WO 02/084384 A1 (UT BATTELLE LLC [US]) 24 October 2002 (2002-10-24) * page 3, line 10 - page 4, line 14 * * page 23, line 4 - line 9 * ----- | 1,5 | |
| A | US 6 215 928 B1 (FRIESEM ASHER A [IL] ET AL) 10 April 2001 (2001-04-10) * column 7, line 13 - column 8, line 45; figures 3,4 * ----- | 1 | |
| A | US 6 778 251 B1 (AUSTIN LINDSAY W [US] ET AL) 17 August 2004 (2004-08-17) * column 17, line 49 - column 18, line 37; figure 19 * ----- | 1 | |
| A | US 2003/002156 A1 (HOBBS DOUGLAS S [US] ET AL) 2 January 2003 (2003-01-02) * paragraph [0052] - paragraph [0065] * ----- | 1 | TECHNICAL FIELDS SEARCHED (IPC) G02F |

The present search report has been drawn up for all claims

| Place of search | Date of completion of the search | Examiner |
|---|---|---|
| The Hague | 5 April 2007 | Diot, Patrick |

## ANNEX TO THE EUROPEAN SEARCH REPORT
## ON EUROPEAN PATENT APPLICATION NO.

EP 06 12 0048

This annex lists the patent family members relating to the patent documents cited in the above-mentioned European search report.
The members are as contained in the European Patent Office EDP file on
The European Patent Office is in no way liable for these particulars which are merely given for the purpose of information.

05-04-2007

| Patent document cited in search report | | Publication date | Patent family member(s) | | Publication date |
|---|---|---|---|---|---|
| WO 2005064365 | A | 14-07-2005 | AU<br>CA<br>EP<br>US | 2003294011 A1<br>2550677 A1<br>1704428 A1<br>2007071061 A1 | 21-07-2005<br>14-07-2005<br>27-09-2006<br>29-03-2007 |
| WO 02084384 | A1 | 24-10-2002 | US | 2002149584 A1 | 17-10-2002 |
| US 6215928 | B1 | 10-04-2001 | EP<br>WO<br>JP<br>JP | 0898799 A2<br>9744686 A2<br>3527513 B2<br>2000514566 T | 03-03-1999<br>27-11-1997<br>17-05-2004<br>31-10-2000 |
| US 6778251 | B1 | 17-08-2004 | EP<br>JP<br>US<br>US<br>WO | 1602004 A2<br>2006518879 T<br>2004165139 A1<br>2004174473 A1<br>2004077133 A2 | 07-12-2005<br>17-08-2006<br>26-08-2004<br>09-09-2004<br>10-09-2004 |
| US 2003002156 | A1 | 02-01-2003 | NONE | | |

EPO FORM P0459

For more details about this annex : see Official Journal of the European Patent Office, No. 12/82

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5346564 A
- JP 10209009 A
- JP 005340321 A
- JP 005221368 A
- JP 005311243 A